# EUROPEAN PATENT SPECIFICATION

(11) **EP 0 393 215 B1**
(45) Date of publication and mention of the grant of the patent: **09.11.1994**
(21) Application number: 89106905.6
(22) Date of filing: 18.04.1989
(51) Int. Cl.: H01L 21/60, H01L 21/90, H01L 21/285, H01L 21/20

(54) **A preparation method of selective growth silicon layer doped with impurities**
Verfahren zum Herstellen einer mit Störatomen dotierten, selektiv gewachsenen Siliziumschicht
Procédé de fabrication d'une couche de silicium déposée sélectivement, dopée avec des impuretés

(43) Date of publication of application: 24.10.1990
(73) Proprietor: KABUSHIKI KAISHA TOSHIBA, Kawasaki-shi, Kanagawa-ken 210 (JP)
(72) Inventor: Samata, Shuichi Intellectual Property Div., Minato-ku Tokyo 105 (JP); Matsushita, Yoshiaki Intellectual Property Div., Minato-ku Tokyo 105 (JP)
(74) Representative: Lehn, Werner, Dipl.-Ing.

(56) References cited:
- EP-A- 0 228 183
- DE-A- 3 636 547
- US-A- 4 714 686
- EXTENDED ABSTRACTS OF THE 20th (1988 INTERNATIONAL) CONFERENCE ON SOLID STATE DEVICES AND MATERIALS, 24th-28th August 1988, pages 565-568, Tokyo, JP; H. KOTANI: "Metallization for ULSI"
- JOURNAL OF THE ELETROCHEMICAL SOCIETY, vol. 135, no. 10, October 1988, pages 2640-2643, Manchester, NH, US; N.F. RALEY et al.: "Fabrication of low-resistance polysilicon via plugs in borophosphosilicate glass"

## Description

This invention relates to a method of manufacturing a semiconductor device, specifically a doping method of doping impurities into a selective growth silicon layer.

A selective growth process is utilized as an effective process for separating fine elements and for manufacturing a contact filling (including, for example, a self-aligning contact).

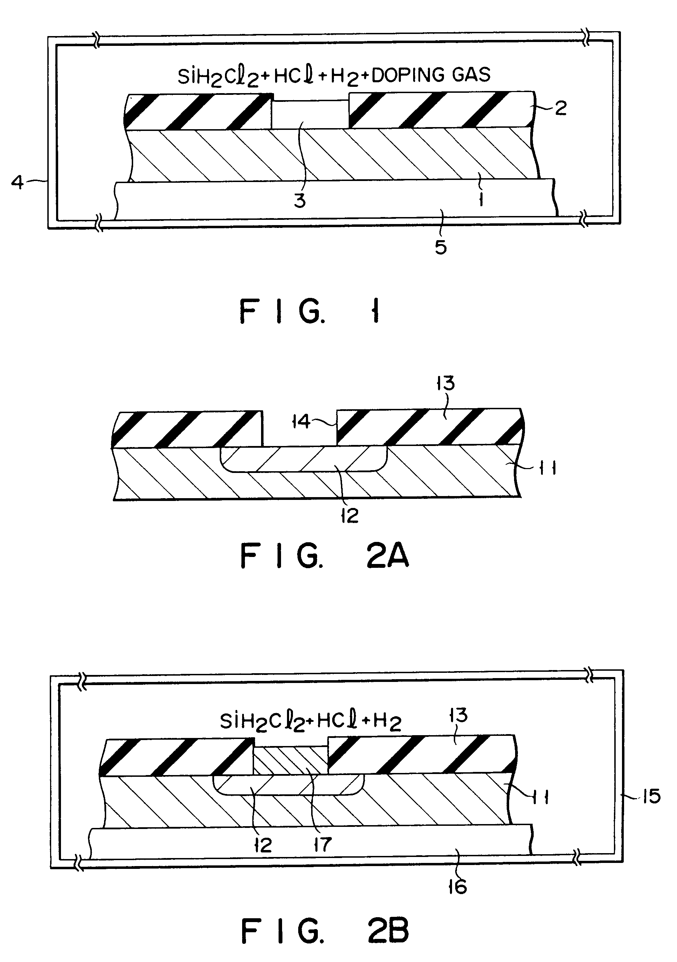

A conventional example utilizing a selective growth process applied to the contact filling technique is described in reference to Fig. 1. An insulating layer 2 having an opening is formed on semiconductor substrate 1. The resultant structure is provided on a susceptor 5 in a reactive furnace 4 (a reactive chamber) for epitaxial growth. For example, by utilizing H₂ as a carrier gas and silicon chloride or hydrogenated silicon as a material gas, and adding HCℓ gas and doping gas (gaseous compounds containing impurity atoms in reactive gas), a gas growth process is conducted under reduced pressure. Consequently, silicon layer 3 containing impurities is grown in said opening.

In said conventional method, the impurity atoms adhere to the inner surfaces of the reactive furnace 4 and the susceptor 5 during the growth of silicon layer 3. The adhered impurity atoms float again in the next selective growth process, and contaminate the next growing silicon layer. Therefore, in order to selectively grow a silicon layer containing P type impurities and a silicon layer containing N type impurities, both a reactive furnace for P type and for N type impurities are needed, which doubles facility costs. Therefore, a technique is desired, to obtain selective growth silicon layers doped with P type impurities and those doped with N type impurities, by utilizing a single reactive furnace for epitaxial growth.

Although a technique is produced to dope impurities in a selective growth silicon layer by implanting ions therein, this technique adversely suffers from the reciprocal relation that a large implantation dose cannot result in a deep implantation, while a deep implantation cannot result in a large implantation dose. As a result it is very difficult to obtain a selective growth silicon layer, whose impurity concentration and depth are both large, by utilizing an ion implantation process. US-A- 4 714 686 concerns a contact according to the pre-characterising portions of independent claims 1 and 4.

The object of the present invention is to provide a method for manufacturing semiconductor devices in which both of P type selective growth silicon layers and N type selective growth silicon layers can be formed, by means of a single reactive furnace for a selective growth.

In order to attain the above object, a method for forming semiconductor devices has steps of:
preparing a semiconductor substrate (31) having a region of a first conductivity type and a region of a second conductivity type;
forming an insulating film on the semiconductor substrate (31);
forming the first opening and the second opening in the insulating membrane, the first opening being connected to the region of the first conductivity type, and the second opening being connected to the region of the second conductivity type, and the first and second openings being substantially formed by the same process;
selectively growing the first semiconductor layer in the first openings (35) and the second semiconductor layer in the second openings (35), the first semiconductor layer and the second semiconductor layer being substantially formed by the same process;
forming the first diffusion source layer (37) of the first conductivity type on said first semiconductor layer, and the second diffusion source layer (38) containing impurities of the second conductivity type on said second semiconductor layer;
diffusing impurities in the first semiconductor layer (36) and the second semiconductor layer (36) by utilizing the first and second diffuse source layers (37, 38) as solid diffusion sources; and
removing the first and said second diffuse source layers (37, 38).

According to the above-identified method, although the final conductivity types of said first semiconductor layer and said second semiconductor layer are different from each other, only a single reactive furnace for selective growth is require. Process costs is accordingly reduced and, since the formation of contact holes which require high mask alignment accuracy is conducted in only one process, for example, the total process is simplified. Although formation of said semiconductor layer which is at least 0.4 µm in thickness and at least 10²⁰ cm⁻³ in its impurity concentration is conventionally difficult, it is easily obtained in the present invention. Therefore, this invention is particularly useful when both P type and N type selective growth semiconductor layers are formed which are at least 0.4 µm in thickness and at least 10²⁰ cm⁻³ in their impurity concentration.

This invention can be more fully understood from the following detailed description when taken in conjunction with the accompanying drawings, in which:
Fig. 1 is a sectional view showing a conventional process for forming a contact filling;
Figs. 2A-2D are sectional views showing contact filling formation processes according to the first and second embodiments of the present invention;
Fig. 3 is a sectional view showing a modified example of said first and second embodiments of the present invention; and
Figs. 4A and 4B are sectional views showing a process for forming CMOS transistor of the third embodiment of the present invention.

Descriptions of the first and second embodiments are as follows with reference to Figs. 2A-2D.

The first embodiment shows formation of a selective growth silicon layer doped with N type impurities, and the second embodiment shows formation of a selective growth silicon layer doped with P type impurities.

The first embodiment: P type silicon substrate (100) 11 whose specific resistance is for example 10 Ωcm is prepared. As ions are implanted into the substrate 11 to form diffusion layer 12 of N type whose impurity concentration is about 1 × 10²⁰ cm⁻³, SiO₂ layer 13 of 600 nm in thickness is formed by steam oxidation for 3 hours. Next, opening 14 is formed in the SiO₂ layer by means of the usual photoetching process (PEP). As a result, such a construction is formed as shown in Fig. 2A.

A construction of Fig. 2A is mounted on susceptor 16 in the reactive furnace (reactive chamber) for an epitaxial growth. By utilizing SiH₂Cℓ₂ + HCℓ + H₂ gas and in an atmosphere of about 100 torr (1 torr = 133.3 Pa), non-doped silicon selective growth is conducted at 900°C. Consequently as shown in Fig. 2B, a non-doped silicon layer 17 (single-crystal silicon and/or polysilicon) of about 600 nm in thickness is formed in the opening 14.

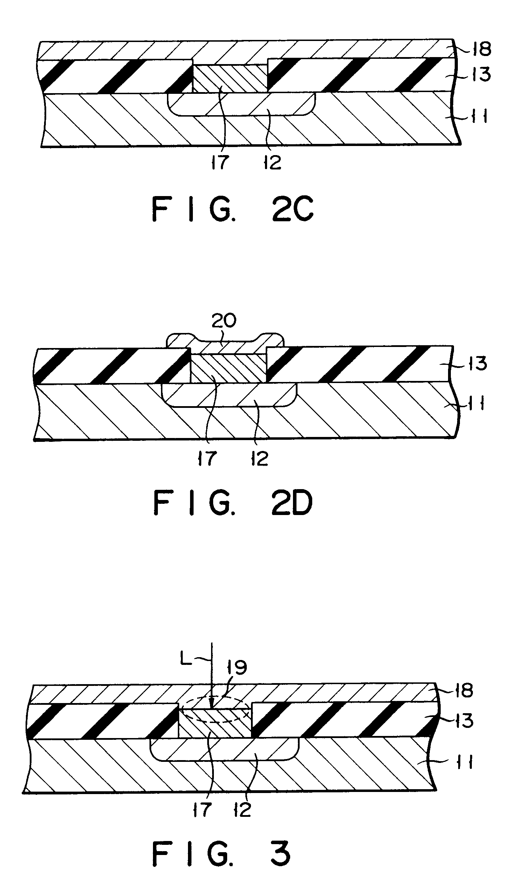

As shown in Fig. 2C, PSG layer 18 which contains N type impurities of about 5 × 10²⁰ ∼ 1 × 10²¹ cm⁻³ is formed on the silicon layer 17. The resultant structure is heated in an O₂ atmosphere at 900°C for 30 minutes, and N type impurities are diffused from the PSG layer 18 into the silicon layer 17. At the same time, impurities are also diffused from the impurity layer 12 into the selective growth silicon layer 17 so that, consequently, selective growth silicon layer 17 doped with N type impurities is formed. Next, PSG layer 18 is removed to form aluminum wiring 20. As a result, a contact filling is formed by utilizing selective growth silicon layer 17 doped with N type impurities.

The second embodiment: N type silicon substrate (100) 11 whose specific resistance is 10 Ωm is formed. P type diffusion layer 12 is formed on the surface of the N type silicon substrate 11 by implanting BF₂ ions in the substrate 11, then steam oxidation is conducted for 3 hours to form SiO₂ layer 13, of 600 nm thickness, and the photoetching process is implemented to form opening 14 therein. Next, non-doped silicon layer is selectively grown at 900°C by utilizing SiH₂Cℓ₂ + HCℓ + H₂ gas. Consequently, non-doped silicon layer 17 of about 600 nm thickness is formed in the opening 14 as shown in Fig. 2B.

As shown in Fig. 2C, BSG layer 18 is formed in the non-doped silicon layer 17. The resultant structure is heated in an O₂ atmosphere at 900°C for 30 minutes to diffuse P type impurities from the BSG layer 18 into the non-doped silicon layer 17. At the same time, P type impurities are also diffused from the impurity layer 12 into the silicon layer 17. Therefore, selective growth silicon layer 17 doped with P type impurities is formed. The BSG layer 18 is removed to form aluminium wiring 20. As a result, a contact-hole filling is formed by utilizing selective growth silicon layer 17 doped with N type impurities as shown in Fig. 2D.

According to said method for doping impurities into a selective growth silicon layer, only one reactive furnace for epitaxial growth is needed, irrespective of the type of final requisite silicon layer, i.e., P type, N type or non-doped. Moreover, since the depth of the PSG layer or BSG layer 18 and the impurity concentration contained therein can be arbitrarily set, this invention can be applied to a silicon layer 17 which has both a high impurity concentration and substantial depth. Also, since the selective growth gas includes no doping gas, the silicon layer growth shows stability and good reproductivity. (When the amount of doping gas is large, the selectivity of silicon growth decreases, of so, a silicon layer may be deposited on the SiO₂ layer 13, and the reproductivity of the growth rate decreases, which eventually leads to serviceability deterioration.)

In said first and second embodiments, impurities are doped into the selective growth silicon layer 17 in an O₂ atmosphere at 900°C for 30 minutes. However, as shown in Fig. 3, boundaries between the layer 17 and the layer 18 and its peripheral area (an area surrounded with broken lines in Fig. 3) may be irradiated by light, e.g. laser light L within 10 minutes, for example, for 2 minutes and partly heated at 800-1200°C, to form diffuse impurities in the silicon layer 17 (rapid anneal).

In order to confirm effects obtained from the methods with reference to said first and second embodiments, semiconductor devices of the same construction were respectively produced according to said first embodiment, second embodiment, first conventional example, and second conventional example both of which are described as follows, and their features are verified. The features verified are contact characteristics between silicon layer 17 and Aℓ wiring 20, and impurity concentration distribution in selective growth silicon layer 17, assayed by secondary ion mass spectrometric analysis.

The first conventional example: Instead of post selective growth processes according to said first embodiment, P doping selective growth is conducted by utilizing SiH₂Cℓ₂ + HCℓ + PH₃ + H₂ gas. Si layer 17 is then formed, and Aℓ wire 20 is formed.

The second conventional example: Instead of post selective growth processes according to said second conventional embodiment, SiH₂Cℓ₂ + HCℓ + B₂H₆ + H₂ gas is utilized to give N dope selective growth. Si layer 17 is then formed, and Aℓ wire 20 is formed.

As a result of comparison, contact characteristics between silicon layer 17 and aluminium wiring layer 20 were found to be almost equal in both the embodiments and conventional examples.

Also, it was found that both the embodiments and conventional examples can realize about 1 × 10²⁰ cm⁻³ (peak value). Therefore, contact filling having sufficiently good characteristics can be obtained from both the conventional examples and the embodiments, with the exception that the selective silicon layer growth is heavily unstable and reproductivity is poor in the conventional examples. For example, since silicon is deposited on SiO₂ layer 13 in some cases, and the growth rate is different for each deposition sequence, the yield of the selective growth silicon layer is low. In conclusion, conventional examples are not practical. Moreover, since the first and second conventional examples implement doping of impurities during selective growth, two reactive furnaces are needed for both P type and N type impurities, while embodiments of the present invention necessitate only a single reactive furnace for selective growth. Although the embodiments need several processes after selective growth, introduction of only a single reactive furnace reduces conventional process costs to about less than 60%.

Moreover, in the semiconductor device obtained by the first and second conventional methods, impurities are diffused from the selective growth silicon layer 17 to the substrate 11 through the diffusion layer 12 during the growth of silicon layer 17. Therefore, a shallow junction is difficult to obtain. By contrast, in said first and second embodiments, the impurities of the non-doped or low-concentration doped selective growth silicon layer 17 do not diffuse into the substrate 11, resulting in a shallow junction. In the embodiments which utilize rapid anneal, a shallow junction, whose depth is at least 70% of that in the conventional examples is obtained.

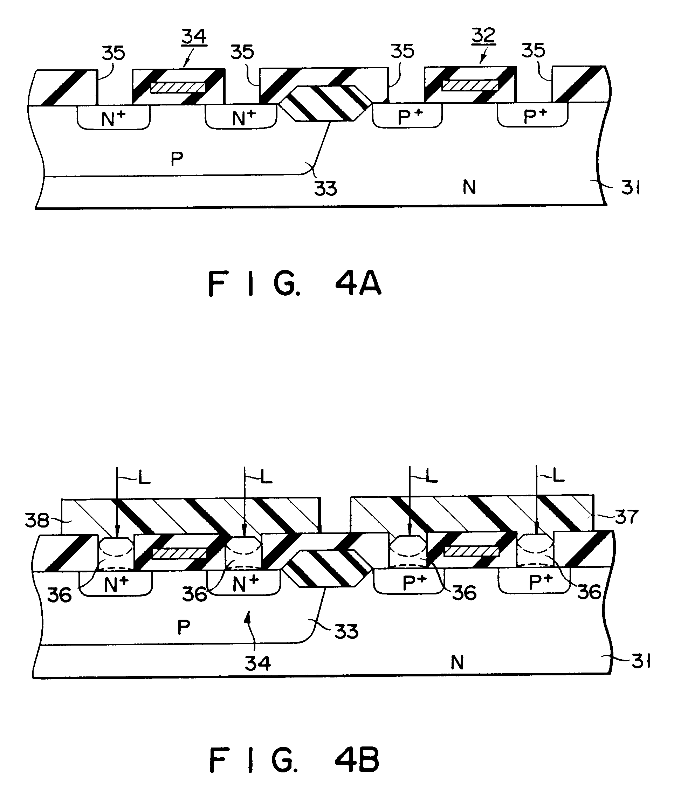

Next, the third embodiment is described with reference to Fig. 4A and Fig. 4B.

P channel MOS transistor 32 is formed on N type substrate 31, and N channel MOS transistor 34 is formed in P type well 33 which is formed on the substrate 31. Contact holes 35 are formed on source regions and drain regions, thus forming the construction shown in Fig. 4A.

The resultant structure is mounted in a reactive furnace, and silicon layers 36 are selectively grown in all contact holes 35. On the P channel MOS transistor, BSG layer 37 is formed containing P type impurities. On the N channel MOS transistor, PSG layer 38 containing N type impurities is formed by a process which is different from that for BSG layer 37. Boundaries between the silicon layer 36 and the BSG layer 37 and between the silicon layer 36 and the PSG layer 38 and those peripheral regions, are irradiated with laser light L and partly heated. Referring to the result as shown in Fig. 4B, broken lines typically indicate that impurities are diffused into the silicon layer 36 not only from the BSG layer 37 and the PSG layer 38, but also from the source regions and the drain regions.

Next, BSG layer 37 and PSG layer 38 are removed, followed by formation of metal (e.g., aluminium) wiring which is connected to the silicon layer 36.

In this manufacturing method of a CMOS semiconductor, formation of selective growth silicon layer 36 needs only a single reactive furnace for selective growth. As stated above, manufacture costs can be duly reduced.

In this manufacturing method of a CMOS transistor, additional processes are needed to form layers 37 and 38 in comparison with the conventional preparation method of a CMOS transistor. However, formation of layers 37 and 38 allows relatively rough mask alignment, for example, a mask alignment accuracy of about 1 µm is sufficient, in contrast to the formation of 1.0 µm contact holes, which necessitate highest mask alignment accuracy in manufacturing a transistor, for example, mask alignment of about 0.2 µm accuracy is needed. This embodiment allows formation of all contact holes by means of only one mask alignment process, and the total processes can be accordingly simplified, in comparison with a conventional preparation method of a CMOS transistor which necessitates two mask alignment processes, one for formation of the contact holes for P type silicon layer, and another for formation of the contact holes for N type silicon layer.

In a procedure of selectively growing a silicon layer under the condition that the silicon layer is doped, insitu, with impurity concentration of more than 10²⁰ cm⁻³, the concentration of doping gas must increase, and the growth condition such as selectivity become less stable. Therefore, silicon is adversely deposited not only in the inner area of openings (contact holes), but also in other regions, for example, on an insulating membrane, which leads to deteriorated stability and reproductivity. Contrarily, since a silicon layer of non-doping or of low doping is formed in the present invention, stability and good reproductivity are obtained. The present invention is thus eminently useful for formation of a selective growth silicon layer containing impurities of more than 10²⁰ cm⁻³ concentration. Moreover, ion implantation in a non-doped selective growth silicon layer shows a reciprocal relation between implantation dose and implantation depth, and it is therefore difficult to form a layer containing impurities of more than 10²⁰ cm⁻³ such that the layer has a constant depth. For example, an implantation dose of about 1 × 10¹⁵ - 1 × 10¹⁶cm⁻² is needed to obtain an impurity concentration of about 10²⁰ cm⁻³ by means of ion implantation. To ensure the implantation dose, accelerated voltage must usually be about 60 keV or less. If the accelerated voltage is about 60 keV, Rp of implantation depth is at most 0.2 µm, depending on the atom species implanted. Therefore, the doping silicon layer which is formed by ion implantation is at most 0.4 µm in depth, even if it is considered that the ion implanted is diffused by heating after ion implantation, and that impurities in the semiconductor substrate are diffused into the selective growth silicon layer. The present invention sets no restrictions in implanted impurity concentration and silicon layer depth. From the above considerations, this invention is found to be eminently effective for the formation of the selective growth silicon layer which is more than 0.4 µm in depth, is more than 10²⁰ cm⁻³ in impurity concentration, and is doped with both P type and N type impurities.

Although said descriptions of the embodiments show selective growth of a silicon layer, this invention is not restricted to silicon and can be applied to, for example, selective growth of a chemical semiconductor, such as GaAs.

Although said descriptions of the embodiments show selective growth of silicon layers 17 and 36 of non-doping, this invention is not restricted to this non-doped selective growth and can be applied to formation of a selective growth silicon layer doped with impurities of relatively low concentration, for example, under 1 × 10¹⁸ cm⁻³, followed by doping of high concentration utilizing, for example, a diffuse source as described in the embodiments. The material of the diffusion source is not limited to the SiO₂ layer. It can be amorphous silicon layer, poly-silicon, or silicon nitride.

## Claims

1. A method of forming a CMOS transistor contact filling comprising steps of preparing
a semiconductor substrate (31) of a first conductivity type;
forming a source region of a second conductivity type and a drain region of the second conductivity type of a MOS transistor (32) of the second conductivity type in said semiconductor substrate (31), and forming a source region of the first conductivity type and a drain region of the first conductivity type of a MOS transistor (34) of the first conductivity type in a well region (33) of the second conductivity type of said semiconductor substrate (31),
forming an insulating layer on said semiconductor substrate,
forming contact holes (35) with a first positioning accuracy wherein each contact hole (35) is connected to a corresponding source region or drain region; by substantially the same process in said insulating layer, characterized by
selectively growing non-doped silicon layers (36) of at least 0.4 µm depth, as electrodes in said contact holes (35);
forming a first diffusion source layer (38) containing impurities of the first conductivity type above said MOS transistor (34) of the first conductivity type with a lower positioning accuracy than said first positioning accuracy, such that the first diffusion source layer (38) is connected to said silicon layers (36), and forming a second diffusion source layer (37) containing impurities of the second conductivity type above said MOS transistor (32) of the second conductivity type with a lower positioning accuracy than said first positioning accuracy, such that the second diffusion source layer (37) is connected to said silicon layers (36);
diffusing impurities into said silicon layers (36), such that peak impurity concentrations are at least 1 × 10²⁰ cm⁻³, utilizing said first diffusion source layer (38) and said second diffusion source layer (37) as solid diffusion sources;
removing said first diffusion source layer (38) and said second diffusion layer (37); and
forming metal wire layers which are connected to said silicon layers (36).

2. A method according to claim 1, characterized in that diffusion of impurities is conducted by a rapid anneal at 800°C to 1200°C within 10 minutes from said first and second solid diffusion source layers into said silicon layers.

3. A method according to claim 1, characterized in that said step of selectively growing has a process for forming said silicon layers in a single reactive furnace for selective growth.

4. A method of manufacturing a semiconductor device, characterized by comprising steps of:
preparing a semiconductor substrate (31) having a region of the first conductivity type and a region of the second conductivity type;
forming an insulating film on said semiconductor substrate (31);
forming a first opening and a second opening in said insulating film, said first opening being connected to said region of the first conductivity type, and said second opening being connected to said region of the second conductivity type characterized by
selectively growing the first semiconductor layer in said first openings (35) and the second semiconductor layer in said second openings (35), said first semiconductor layer and said second semiconductor layer being formed by substantially the same process;
forming the first diffusion source layer (37) of the first conductivity type on said first semiconductor layer and the second diffusion source layer (38) containing impurities of the second conductivity type on said second semiconductor layer;
diffusing impurities in said first semiconductor layer (36) and said second semiconductor layer (36) by utilizing said first diffusion source layer (38) and said second diffusion source layer (37) as solid diffusion sources; and
removing said first diffusion source layer (38) and said second diffusion source layer (37).

5. A method according to claim 4, characterized in that
said step of forming said first opening and said second opening (35) is to form said first opening and said second opening, by substantially the same process;
said selective growth step is to form said first semiconductor layer and said second semiconductor layer by substantially the same process; and
said step of forming said first and second diffusion source layers (37, 38) is to form said first and second diffusion layers, with less positioning accuracy than that in said step of forming openings.

6. A method according to claim 4, characterized in that
said step of forming semiconductor layer is to form said semiconductor layer to a thickness of at least 0.4 µm in thickness by utilizing a selective growth process, and
said impurities diffusion step of diffusing impurities into said semiconductor layer (17) is such that the peak impurity concentration is at least 1 × 10²⁰ cm⁻³.

7. A method according to claim 4, characterized in that said growing step is to form said semiconductor layer by selectively growing a non-doped silicon layer (36).

8. A method according to claim 4, characterized in that said growing step is to form said first and second semiconductor layers in a single reactive furnace for a selective growth.

9. A method according to claim 4, characterized in that diffusion of impurities is conducted by a rapid anneal at 800°C to 1200°C within 10 minutes from said first and second solid diffuse source layers into said silicon layers.

## Patentansprüche

1. Verfahren zur Herstellung einer CMOS-Transistor-Kontaktfüllung, aufweisend Schritte zum Herstellen eines Halbleitersubstrats (31) eines ersten Leitfähigkeitstyps;
Bilden eines Source-Bereichs eines zweiten Leitfähigkeitstyps und eines Drain-Bereichs des zweiten Leitfähigkeitstyps eines MOS-Transistors (32) des zweiten Leitfähigkeitstyps im Halbleitersubstrat (31), und Bilden eines Source-Bereichs des ersten Leitfähigkeitstyps und eines Drain-Bereichs des ersten Leitfähigkeitstyps eines MOS-Transistors (34) des ersten Leitfähigkeitstyps in einem Muldenbereich (33) des zweiten Leitfähigkeitstyps des Halbleitersubstrats (31);
Bilden einer Isolierschicht auf dem Halbleitersubstrat;
Bilden von Kontaktlöchern (35) mit einer ersten Positionierungsgenauigkeit, wobei jedes Kontaktloch (35) an einen entsprechenden Source-Bereich oder DrainBereich angeschlossen ist, durch im wesentlichen die gleiche Prozedur in der Isolierschicht;
**gekennzeichnet** durch:
selektives Aufwachsen von nichtdotierten Siliziumschichten (36) von mindestens 0,4 µm Tiefe als Elektroden in den Kontaktlöchern (35);
Bilden einer ersten Diffusionsquellenschicht (38), die Fremdatome des ersten Leitfähigkeitstyps über dem MOS-Transistor (34) des ersten Leitfähigkeitstyps mit einer geringeren Positionierungsgenauigkeit als die erstegenannte Positionierungsgenauigkeit enthält, derart, daß die erste Diffusionsquellenschicht (38) mit den ersten Siliziumschichten (36) verbunden wird; und Bilden einer zweiten Diffusionsquellenschicht (37), die Fremdatomn des zweiten Leitfähigkeitstyps über dem MOS-Transistor (32) des zweiten Leitfähigkeitstyps mit einer geringeren Positionierungsgenauigkeit als der erstgenannten Positionierungsgenauigkeit enthält, derart, daß die zweite Diffusionsquellenschicht (37) mit den Siliziumschichten (36) verbunden wird;
Diffundieren der Fremdatome in die Siliziumschichten (36), derart, daß Fremdatomspitzenkonzentrationen mindestens 1 x 10²⁰ cm⁻³ betragen, unter Benutzung der ersten Diffusionsquellenschicht (38) und der zweiten Diffusionsquellenschicht (37) als Festkörperdiffusionsquellen;
Beseitigen der ersten Diffusionsquellenschicht (38) und der zweiten Diffusionsquellenschicht (37); und
Bilden von Metalldrahtschichten, die mit den Siliziumschichten (36) verbunden sind.

2. Verfahren nach Anspruch 1, dadurch gekennzeichnet, daß die Diffusion von Fremdatomen aus den ersten und zweiten massiven Diffusionsquellenschichten in die Siliziumschichten durch eine Schnellglühung bei 800°C bis 1200°C innerhalb von 10 Minuten durchgeführt wird.

3. Verfahren nach Anspruch 1, dadurch gekennzeichnet, daß der Schritt des selektiven Aufwachsens eine Prozedur zur Bildung der Siliziumschichten in einem einzelnen Reaktionsofen für selektives Aufwachsen umfaßt.

4. Verfahren zum Herstellen einer Halbleitervorrichtung, dadurch gekennzeichnet, daß es folgende Schritte aufweist:
Herstellen eines Halbleitersubstrats (31), das ein erstes Gebiet des ersten Leitfähigkeitstyps, und ein Gebiet des zweiten Leitfähigkeitstyps besitzt;
Bilden eines Isolierfilms auf dem Halbleitersubstrat (31);
Bilden einer ersten Öffnung und einer zweiten Öffnung in dem Isolierfilm, wobei die erste Öffnung mit dem Gebiet des ersten Leitfähigkeitstyps und die zweite Öffnung mit dem Gebiet des zweiten Leitfähigkeitstyps verbunden ist,
**gekenzeichnet** durch
selektives Aufwachsen der ersten Halbleiterschicht in den ersten Öffnungen (35) und der zweiten Halbleiterschicht in den zweiten Öffnungen (35), wobei die erste Halbleiterschicht und die zweite Halbleiterschicht im wesentlichen durch die gleiche Prozedur gebildet werden;
Bilden der ersten Diffusionsquellenschicht (37) des ersten Leitfähigkeitstyps auf der ersten Halbleiterschicht, und der zweiten Diffusionsquellenschicht (38), die Fremdatome des zweiten Leitfähigkeitstyps enthält, auf der zweiten Halbleiterschicht;
Diffundieren von Fremdatomen in die erste Halbleiterschicht (36) und in die zweite Halbleiterschicht (36) durch Benutzen der ersten Diffusionsquellenschicht (37) und der zweiten Diffusionsquellenschicht (38) als Festkörperdiffusionsquellen; und
Beseitigen der ersten Diffusionsquellenschicht (37) und der zweiten Diffusionsquellenschicht (38).

5. Verfahren nach Anspruch 4, dadurch gekennzeichnet, daß
der Schritt der Bildung der ersten Öffnung und der zweiten Öffnung (35) darin besteht, die erste Öffnung und die zweite Öffnung durch im wesentlichen die gleiche Prozedur herzustellen;
der Schritt des selektiven Aufwachsens darin besteht, die erste Halbleiterschicht und die zweite Halbleiterschicht durch im wesentlichen die gleiche Prozedur zu bilden; und
der Schritt der Bildung der ersten und der zweiten Diffusionsquellenschichten (37, 38) darin besteht, die erste und die zweite Diffusionsquellenschicht mit einer geringeren Positionierungsgenauigkeit als die des Schrittes zur Herstellung der Öffnungen zu bilden.

6. Verfahren nach Anspruch 4, dadurch gekennzeichnet, daß
der Schritt der Bildung der Halbleiterschicht darin besteht, die Halbleiterschicht bis zu einer Dicke von mindestens 0,4 µm unter Anwendung der Prozedur des selektiven Aufwachsens zu bilden; und
der Fremdatomdiffusionsschritt zum Diffundieren von Fremdatomen in die Halbleiterschicht (17) so erfolgt, daß die Fremdatomspitzenkonzentration mindestens 1 x 10²⁰ cm⁻³ beträgt.

7. Verfahren nach Anspruch 4, dadurch gekennzeichnet, daβ der Aufwachsschritt darin besteht, die Halbleiterschicht durch selektives Aufwachsen einer nichtdotierten Siliziumschicht (36) zu bilden.

8. Verfahren nach Anspruch 4, dadurch gekennzeichnet, daß der Aufwachsschritt darin besteht, die erste und die zweite Halbleiterschicht in einem einzelnen Reaktionsofen für selektives Aufwachsen zu bilden.

9. Verfahren nach Anspruch 4, dadurch gekennzeichnet, daß die Diffusion von Fremdatomen aus der ersten und der zweiten Festkörper-Diffusionsquellenschicht in die Siliziumschichten durch eine rasche Glühung bei 800°C bis 1200°C durchgeführt wird.

## Revendications

1. Procédé de formation d'un remplissage de contacts d'un transistor CMOS, comprenant les étapes suivantes :
la préparation d'un substrat semi-conducteur (31) d'un premier type de conductivité,
la formation d'une région de source d'un second type de conductivité et d'une région de drain du second type de conductivité d'un transistor MOS (32) du second type de conductivité dans le substrat semi-conducteur (31), et la formation d'une région de source du premier type de conductivité et d'une région de drain du premier type de conductivité d'un transistor MOS (34) du premier type de conductivité dans une région de puits (33) du second type de conductivité du substrat semi-conducteur (31),
la formation d'une couche isolante sur le substrat semi-conducteur, et
la formation de trous de contact (35) avec une première précision de positionnement, chaque trou de contact (35) étant connecté à une région correspondante de source ou de drain, pratiquement par la même opération dans la couche isolante, caractérisé par
la croissance sélective de couches (36) de silicium non dopées ayant une épaisseur d'au moins 0,4 µm, comme électrodes dans les trous de contact (35),
la formation d'une première couche (38) de source de diffusion contenant des impuretés du premier type de conductivité au-dessus du transistor MOS (34) du premier type de conductivité avec une précision de positionnement inférieure à la première position de positionnement, si bien que la première couche de source de diffusion (38) est connectée aux couches de silicium (36), et la formation d'une seconde couche (37) de source de diffusion contenant des impuretés du second type de conductivité au-dessus du transistor MOS (32) du second type de conductivité avec une précision de positionnement inférieure à la première précision de positionnement, de manière que la seconde couche (37) de source de diffusion soit connectée aux couches (36) de silicium,
la diffusion d'impuretés dans les couches (36) de silicium afin que des concentrations maximales d'impuretés atteignent au moins 1.10²⁰ cm⁻³, par utilisation de la première couche (38) et de la seconde couche (37) de source de diffusion comme sources solides de diffusion,
l'extraction de la première couche (38) et de la seconde couche (37) de source de diffusion, et
la formation de couches de câblage métallique qui sont connectées aux couches (36) de silicium.

2. Procédé selon la revendication 1, caractérisé en ce que la diffusion des impuretés est réalisée par recuit rapide entre 800 et 1 200 °C en moins de 10 min, de la première et de la seconde couche solide de source de diffusion aux couches de silicium.

3. Procédé selon la revendication 1, caractérisé en ce que l'étape de croissance sélective comprend une opération de formation des couches de silicium dans un seul four de réaction pour la croissance sélective.

4. Procédé de fabrication d'un dispositif à semiconducteur, caractérisé en ce qu'il comprend les étapes suivantes :
la préparation d'un substrat semi-conducteur (31) ayant une région du premier type de conductivité et une région du second type de conductivité,
la formation d'un film isolant sur le substrat semiconducteur (31),
la formation d'une première ouverture et d'une seconde ouverture dans le film isolant, la première ouverture étant connectée à ladite région du premier type de conductivité e la seconde ouverture étant connectée à ladite région du second type de conductivité, caractérisé par les étapes suivantes :
la croissance sélective de la première couche semiconductrice dans les premières ouvertures (35) et de la seconde couche semi-conductrice dans les secondes ouvertures (35), la première couche semi-conductrice et la seconde couche semi-conductrice étant formées pratiquement par la même opération,
la formation de la première couche (37) de source de diffusion du premier type de conductivité sur la première couche semi-conductrice et de la seconde couche (38) de source de diffusion contenant des impuretés du second type de conductivité sur la seconde couche semi-conductrice,
la diffusion d'impuretés dans la première couche semi-conductrice (36) et la seconde couche semi-conductrice (36) par utilisation de la première couche (38) et de la seconde couche (37) de source de diffusion comme sources solides de diffusion, et
l'extraction de la première couche (38) et de la seconde couche (37) de source de diffusion.

5. Procédé selon la revendication 4, caractérisé en ce que
l'étape de formation de la première ouverture et de la seconde ouverture (35) comprend la formation de la première ouverture et de la seconde ouverture pratiquement par la même opération,
l'étape de croissance sélective comprend la formation de la première couche semi-conductrice et de la seconde couche semi-conductrice pratiquement par la même opération, et
l'étape de formation de la première et de la seconde couche (37, 38) de source de diffusion est destinée à former la première et la seconde couche de diffusion avec une précision de positionnement inférieure à celle de l'étape de formation des ouvertures.

6. Procédé selon la revendication 4, caractérisé en ce que
l'étape de formation de la couche semi-conductrice comprend la formation d'une couche semi-conductrice avec une épaisseur d'au moins 0,4 µm par utilisation d'une opération de croissance sélective, et
l'étape de diffusion d'impuretés dans la couche semi-conductrice (17) est telle que la concentration maximale d'impuretés est au moins égale à 1.10²⁰ cm⁻³.

7. Procédé selon la revendication 4, caractérisé en ce que l'étape de croissance est destinée à former la couche semi-conductrice par croissance sélective d'une couche de silicium non dopée (36).

8. Procédé selon la revendication 4, caractérisé en ce que l'étape de croissance est destinée à former la première et la seconde couche semi-conductrice dans un seul four de réaction destiné à la croissance sélective.

9. Procédé selon la revendication 4, caractérisé en ce que la diffusion des impuretés est réalisée par un recuit rapide entre 800 et 1 200 °C en moins de 10 min de la première et de la seconde couche de source solide de diffusion vers les couches de silicium.
